# EUROPÄISCHE PATENTSCHRIFT

(11) **EP 1 936 395 B1**
(45) Veröffentlichungstag und Bekanntmachung des Hinweises auf die Patenterteilung: **29.10.2014**
(21) Anmeldenummer: 07024037.9
(22) Anmeldetag: 12.12.2007
(51) Int. Cl.: G01R 31/28

(54) **Kontaktiervorrichtung für eine Berührungskontaktierung eines elektrischen Prüflings sowie entsprechendes Verfahren**
Contacting device for touch contacting of an electrical device to be tested and corresponding method
Dispositif de contact pour un contact tactile d'un composant électrique à tester et procédé correspondant

(30) Priorität: 19.12.2006 DE 102006062391; 30.11.2007 DE 102007057815
(43) Veröffentlichungstag der Anmeldung: 25.06.2008
(73) Patentinhaber: Feinmetall GmbH, 71083 Herrenberg (DE)
(72) Erfinder: Böhm, Gunther, 71154 Nufringen (DE); Weiland, Achim, 71157 Hildrizhausen (DE)
(74) Vertreter: Grosse, Rainer

(56) Entgegenhaltungen:
- EP-A1- 1 596 204
- EP-A1- 1 600 782
- US-A- 5 210 485
- US-A1- 2003 057 975

## Beschreibung

Die Erfindung betrifft eine Kontaktiervorrichtung für eine Berührungskontaktierung eines elektrischen Prüflings, insbesondere Wafers, mit einem Kontaktkopf, der auch als Kontakt-Head bezeichnet werden kann, und mit einer Verbindungsvorrichtung, auch Connector genannt, wobei der Kontaktkopf mit dem Prüfling elektrisch berührungskontaktierbare Prüfkontakte aufweist, deren über eine Prüffläche verteilte Positionen von mindestens einem zum Kontaktkopf gehörenden Führungselement (Führungsplatte testerseitig) bestimmt sind, das an einer Haltevorrichtung, auch Spacer genannt, des Kontaktkopfs befestigt ist, und wobei die Prüfkontakte auf ihrer dem Prüfling abgewandten Seite mit Kontaktflächen der Verbindungsvorrichtung (Connector, der insbesondere als Leiterplatte ausgebildet sein kann) in elektrische Berührungskontaktierung zu bringen sind.

Derartige Kontaktiervorrichtungen, die auch als Vertikal-Prüfkarten zu bezeichnen sind, bestehen jeweils im Wesentlichen aus dem Kontaktkopf, der die Prüfkontakte (auch Kontaktelemente genannt) trägt und aus der Verbindungsvorrichtung (Connector oder Anschlusskopf), der die elektrische Verbindung zwischen den Profkontakten und einem Testgerät (Tester) herstellt. Der Kontaktkopf ist an der Verbindungsvorrichtung montiert. Die der Verbindungsvorrichtung zugewandten Enden der Prüfkontakte berührungskontaktieren Kontaktflächen der Verbindungsvorrichtung. Die der Verbindungsvorrichtung abgewandt liegenden Enden der Prüfkontakte dienen zur Berührungskontaktierung eines Prüflings, insbesondere eines Wafers. Damit ist es insgesamt möglich, mittels des Testgerätes elektrische Verbindungspfade zum Prüfling herzustellen und diesen auf elektrische Funktion zu prüfen. Die Verbindungsvorrichtung (Connector) besteht bevorzugt aus einer Leiterplatte und gegebenenfalls aus einem so genannten Stiffener, also einem Versteifungselement, das beim Kontaktieren des Prüflings die Kontaktierkräfte aufnehmen kann, ohne dass es zu einem Durchbiegen der Leiterplatte kommt. Die Leiterplatte weist die erwähnten Kontaktflächen auf, das heißt, die Prüfkontakte des Kontaktkopfes können die entsprechenden Kontaktflächen der Leiterplatte direkt kontaktieren. Man spricht hier auch von der Bauform "Direct Attach". Alternativ ist es auch möglich, dass die Leiterplatte von den Prüfkontakten über Zwischendrähte, die zur Entflechtung eingesetzt werden, kontaktiert werden. Man spricht dann von einem verdrahteten Anschlusskopf, also einer verdrahteten Verbindungsvorrichtung, die auch als Wired Connector" bezeichnet wird. Der jeweils an der Verbindungsvorrichtung zu kontaktierende Bereich (Kontaktfläche) ist sehr klein. Er hat insbesondere einen Durchmesser zwischen 50 µm und 300 µm. Dieser geringe Durchmesser ist dadurch bedingt, dass die Prüfkontakte entsprechend der Anordnung der zu kontaktierenden Pads (Kontaktpads) auf dem Prüfling, insbesondere Wafer, sehr eng beieinander liegen, zum Beispiel mit Mittenabständen zwischen 50 µm und 250 µm. Die Anordnung der Kontaktflächen auf der Verbindungsvorrichtung, insbesondere der Leiterplatte (PCB), entspricht der korrespondierenden Kontaktpadsanordnung auf dem Prüfling, insbesondere Wafer, bis auf gegebenenfalls vorliegende geringe Abweichungen durch eine möglichst geringe Schrägstellung von Prüfkontakten. Sofern die Prüfkontakte jedoch nicht schräg gestellt verlaufen, sondern insbesondere vertikal ausgerichtet sind, entsprechen die Mittenabstände der Kontaktpads auf dem Prüfling etwa den Mittenabständen der Kontaktflächen der Verbindungsvorrichtung. Um nun das erwähnte Testgerät mit der Verbindungsvorrichtung elektrisch verbinden zu können, übernimmt die Verbindungsvorrichtung eine Vergrößerung der Kontaktabstände dadurch, dass ihre dem Prüfkopf zugeordneten Kontaktflächen zu hinreichend weit zueinander beabstandeten Kontaktflächen führen, die mit dem Testgerät problemlos verbunden werden können. Bevorzugt befinden sich die Kontaktflächen, die mit den Prüfkontakten kontaktieren, auf der einen Seite der Leiterplatte und die Kontaktflächen, die mit dem Testgerät kontaktiert werden, auf der anderen Seite der Leiterplatte.

Die gesamten vorstehenden Ausführungen treffen auf bekannte Kontaktiervorrichtungen als auch auf Kontaktiervorrichtungen der Erfindung zu. Es wird deutlich, dass das Berührungskontaktieren der Prüfkontakte (Kontaktelemente) mit den zugeordneten Kontaktflächen der Verbindungsvorrichtung dann problematisch sein kann, wenn keine Fluchtung besteht, sondern beispielsweise alle oder einzelne Prüfkontakte versetzt zu zugeordneten Kontaktflächen an der Verbindungsvorrichtung anliegen, das heißt, es wird keine elektrische Kontaktierung erzielt. Dieser Versatz kann beispielsweise aufgrund von Temperaturspiel bewirkt werden.

EP 1596204 und US 5210485 offenbaren solche Kontaktiervorrichtungen.

Der Erfindung liegt daher die Aufgabe zugrunde, eine Kontaktiervorrichtung der eingangs genannten Art kontaktsicherer auszugestalten.

Diese Aufgabe wird erfindungsgemäß durch den Anspruch 1 gelöst.

Nach einer Weiterbildung der Erfindung ist vorgesehen, dass die Haltevorrichtung einen Haltering aufweist, in dessen Inneren die Prüffläche liegt. Unter Prüffläche ist der geometrische Bereich zu verstehen, in dem sich die Prüfkontakte befinden, innerhalb dem somit der Prüfling kontaktiert werden kann.

Es ist vorteilhaft, wenn mindestens eines der Einzelsegmente mittels seines Festlagers mit dem Haltering verbunden ist. Das Einzelsegment ist damit im Befestigungspunkt des Festlagers am Haltering gehalten, das heißt, Längenausdehnungen aufgrund von Temperaturänderungen gehen vom Befestigungspunkt aus: Sie sind im Befestigungspunkt Null und nehmen mit dem Abstand vom Befestigungspunkt entsprechend in Aufsummation zu, verlaufen jedoch nur bis an den Rand des Einzelsegments, wobei diese Entfernung aufgrund der Segmentierung des Führungselements entsprechend klein ist und damit mögliche durch Temperaturspiel bewirkte Versatzmaße klein bleiben.

Es ist vorteilhaft, wenn der Haltering einen kreisförmigen oder einen rechteckigen, insbesondere quadratischen, Grundriss aufweist. Der Haltering kann insbesondere ein Vollring oder ein Teilring sein. Bei einem Vollring handelt es sich um einen geschlossenen Ring; ein Teilring ist nicht geschlossen. Es ist selbstverständlich auch mbglich, dass der Haltering von mehreren Teilringstücken gebildet wird.

Eine Weiterbildung der Erfindung sieht mindestens ein Einzelsegment vor, das mit dem Haltering verbunden ist und ein äußeres Einzelsegment bildet, sowie mindestens ein Einzelsegment, das sich innerhalb des Halterings befindet, jedoch nicht oder nicht direkt mit dem Haltering verbunden ist und ein inneres Einzelsegment bildet. Das mindestens eine äußere Einzelsegment steht somit über ein Festlager mit dem Haltering in Verbindung und das mindestens eine innere Einzelsegment ist nicht mit dem Haltering verbunden, sondern wird insbesondere von dem mindestens einen äußeren Halteelement gehalten und/oder wird von einem anderen Element gehalten, das wiederum mit dem Haltering verbunden ist. Alternativ ist es auch möglich, dass nur äußere Einzelsegmente vorhanden sind.

Nach einer Weiterbildung der Erfindung ist vorgesehen, dass die Haltevorrichtung einen Haltesteg aufweist, an dem mittels mindestens eines Festlagers mindestens ein inneres Einzelsegment befestigt ist. Dieser Haltesteg kann bevorzugt am Haltering befestigt sein. Dabei verläuft der Haltesteg bevorzugt quer durch die Ringstruktur des Halterings, nämlich entlang einer Halteringdiagonalen.

Der Einzelsegmenten sind jeweils mindestens ein Loslager zugeordnet . Demzufolge ist jedes Einzelsegment mit mindestens einem Festlager gehalten und weist jeweils mindestens ein Loslager auf, das eine Relativbewegung gestattet, also eine Längenänderungsverlagerung des entsprechenden Einzelsegment vorzugsweise in mindestens eine Vorzugsrichtung, insbesondere in nur eine Vorzugsrichtung, gestattet. Damit sind die durch Temperaturspiel auftretenden Längenänderungen jedes Einzelsegments kontrolliert.

Nach einer Weiterbildung der Erfindung ist das Loslager zwischen mindestens einem Einzelsegment und der Haltevorrichtung und/oder der Verbindungsvorrichtung einerseits und/oder zwischen mindestens einem Einzelsegment und mindestens einem anderen Einzelsegment andererseits ausgebildet. Die Loslagerverbindung liegt also zwischen dem entsprechenden Einzelsegment und der Haltevorrichtung beziehungsweise Verbindungsvorrichtung vor und/oder zwischen dem Einzelsegment und einem vorzugsweise angrenzenden anderen Einzelsegment.

Das Festlager ist als in der Prüffläche spielfreie Befestigung, insbesondere Verstiftung, ausgebildet. Mithin lässt die spielfreie Befestigung keine Relativbewegungen, egal in welcher Richtung, im Befestigungspunkt des Festlagers zu.

Das Loslager ist als in der Prüffläche in nur einer Richtung mit Spiel versehene Befestigung, insbesondere Verstiftung, ausgebildet. Bei einer durch Temperaturspiel auftretenden Bewegung wird diese somit in diese eine Richtung gelenkt. Wird als Befestigung eine Verstiftung gewählt, so ist diese nicht allseitig spielfrei, sondern weist in der einen, eine Bewegung zulassenden Richtung ein Spiel auf (zum Beispiel Stift in einem Langloch).

Nach einer Weiterbildung der Erfindung ist vorgesehen, dass eine gedachte Verbindungslinie oder eine Verlängerung einer gedachten Verbindungslinie zwischen Festlager und Loslager von jedem der äußeren Einzelsegmente durch oder etwa durch einen Mittelpunkt der Prüffläche verläuft, wobei das Spiel des zugehörigen Loslagers nur in Richtung der Verbindungslinie besteht. Diese Ausgestaltung hat zur Folge, dass Längenänderungen durch Temperaturspiel bei jedem der Einzelsegmente in Bezug auf den Mittelpunkt radial oder etwa radial verlaufen.

Es ist vorteilhaft, wenn das Festlager des mindestens einen inneren Einzelsegments im oder etwa im Mittelpunkt der Prüffläche liegt. Das innere Einzelsegment ist bevorzugt zentral oder etwa zentral im Hinblick auf die geometrische Ausdehnung der Prüffläche angeordnet, wobei die Befestigung des Einzelsegments mittels des zugehörigen Festlagers ebenfalls zentral, nämlich im Mittelpunkt oder etwa im Mittelpunkt der Prüffläche erfolgt.

Nach einer Weiterbildung der Erfindung ist vorgesehen, dass die in der Prüfebene in nur einer Richtung mit Spiel versehene, das Loslager bildende Befestigung zwischen dem einen und dem anderen Einzelsegment als Vorsprungs-/Ausnehmungsverbindung, insbesondere von Bereichen des Führungselements, gebildet ist. Das Loslager wird somit durch Ineinandergreifen von zwei Einzelsegmenten gebildet, indem das eine Einzelsegment einen Vorsprung aufweist, der in eine Ausnehmung des anderen Einzelsegments eingreift, insbesondere spielfrei eingreift, insbesondere quer zur Eingriffsrichtung spielfrei eingreift. In Eingriffsrichtung ist Spiel möglich, das heißt, der Vorsprung kann mehr oder weniger tief in die Ausnehmung eingreifen, sodass in Eingriffsrichtung Verlagerungen möglich sind.

Nach einer Weiterbildung der Erfindung ist vorgesehen, dass das Führungselement einen von der Verbindungsvorrichtung abweichenden Temperaturausdehnungskoeffizienten aufweist. Die Temperaturausdehnungskoeffizienten der bei der Kontaktiervorrichtung verwendeten Bauteile und/oder Materialien sind unterschiedlich. Hinzu kommt, dass diese Bauteile und/oder Materialien während des Tests eines Prüflings unterschiedliche Temperaturen erreichen, sodass Positionsfehler der einzelnen Bauteile zueinander, insbesondere in der bereits erwähnten Berührungsschnittstetle zwischen Kontaktkopf und Verbindungsvorrichtung entstehen. Wenn nun für das Führungselement einerseits und für die Verbindungsvorrichtung andererseits Bauteile/Materialien gewählt werden, die abweichende Temperaturausdehnungskoeffizienten aufweisen, so können die vorstehend erwähnten Parameter, beispielsweise die unterschiedliche Erwärmung verschiedener Stellen der Kontaktiervorrichtung, ganz oder teilweise kompensiert werden, mit der Folge, dass keine Fluchtungsfehler auftreten oder nur geringe, die eine Berührungskontaktierung nicht behindern. Dabei kann insbesondere vorgesehen sein, dass die Haltevorrichtung einen vom Führungselement abweichenden Temperaturausdehnungskoeffizienten aufweist, Insbesondere kann dabei vorgesehen sein, dass die Summe der Temperaturausdehnungskoeffizienten von Führungselement und Haltevorrichtung dem oder etwa dem Temperaturausdehnungskoeffizienten der Verbindungsvorrichtung entspricht. Damit lassen sich Versetzungsfehler vermeiden oder klein halten.

Nach einer Weiterbildung der Erfindung ist vorgesehen, dass der Temperaturausdehnungskoeffizient der Haltevorrichtung derart gewählt ist, dass innerhalb eines Temperaturbereichs die Berührungskontaktierung zwischen den Prüfkontakten und den Kontaktflächen der Verbindungsvorrichtung möglich ist. Damit ist eine sichere Kontaktierung gewährleistet.

Wie bereits erwähnt, kann die Verbindungsvorrichtung als Leiterplatte, insbesondere als gedruckte Leiterplatte ausgebildet sein.

Die Anordnung ist vorzugsweise derart getroffen, dass die Kontaktflächen von Leiterbahnflächen der gedruckten Leiterplatte gebildet sind. Die Prüfkontakte können bevorzugt als Prüfnadeln, insbesondere Prüfknicknadeln, ausgebildet sein. Unter "Prüfknicknadeln" sind Prüfnadeln zu verstehen, die seitlich ausknicken können, also eine Eigenelastizität aufweisen, sodass Kontaktniveauunterschiede ausgeglichen werden und ferner ein entsprechender Kontaktdruck realisiert werden kann.

Insbesondere ist vorgesehen, dass das Führungselement als Führungsplatte ausgebildet ist, es handelt sich demzufolge um ein Flächengebilde.

Die Erfindung betrifft ferner ein Verfahren gemäss dem Anspruch 22 zur Berührungskontaktierung eines elektrischen Prüflings, insbesondere Wafers, mit einem Kontaktkopf (Kontakt-Head) und einer Verbindungsvorrichtung (Connector), wobei der Kontaktkopf mit dem Prüfling elektrisch berührungskoritaktierbare Profkontakte aufweist, deren über eine Prüffläche verteilte Positionen von mindestens einem zum Kontaktkopf gehörenden Führungselement (Führungsplatte testerseitig) bestimmt sind, das an einer Haltevorrichtung (Spacer) des Kontaktkopfs befestigt ist, und wobei die Prüfkontakte auf ihrer dem Prüfling abgewandten Seite mit Kontaktflächen der Verbindungsvorrichtung (Connector, Leiterplatte) in elektrische Berührungskontaktierung zu bringen sind, wobei sich das Führungselement aus Einzelsegmenten zusammensetzt, die jeweils einen Anteil der Prüffläche aufweisen und jeweils mittels mindestens eines Festlagers mit der Haltevorrichtung und/oder der Verbindungsvorrichtung verbunden sind.

Die Zeichnungen veranschaulichen die Erfindung anhend von Ausführungsbeispielen, und zwar zeigt:
- Figur 1: eine schematische Querschnittsansicht durch eine Kontaktiervorrichtung,
- Figur 2: eine Draufsicht auf ein Führungselement einer aus dem Stand der Technik bekannten Kontaktiervorrichtung,
- Figur 3: eine Draufsicht auf ein erfindungsgemäßes Führungselement mit Haltevorrichtung (Spacer) im nicht erwärmten Zustand,
- Figur 4: die Darstellung der Figur 3, jedoch im erwärmten Zustand und
- Figur 5: eine Teilansicht eines Bereichs der Figur 4.

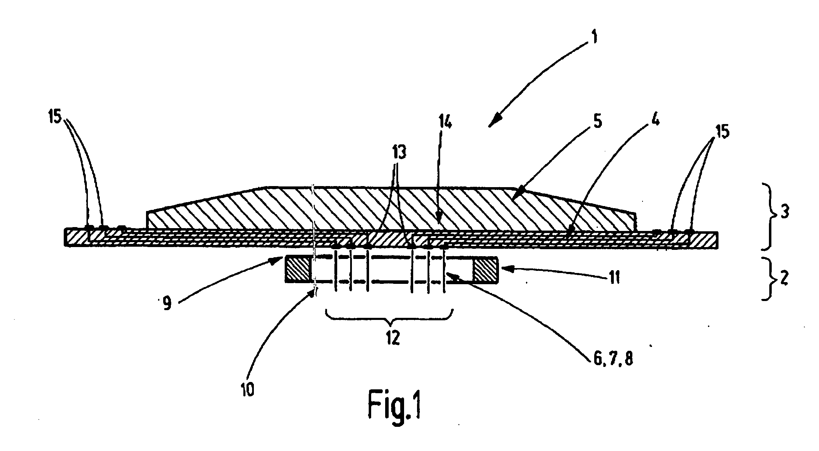

Die Figur 1 zeigt eine Kontaktiervorrichtung 1, die als Vertikalprüfkarte in Direct-Attach-Bauform ausgebildet ist. Dargestellt ist ein Querschnitt der Kontaktiervorrichtung 1, die einen Kontaktkopf 2 und eine Verbindungsvorrichtung 3 aufweist. Die Verbindungsvorrichtung 3 weist eine gedruckte Leiterplatte 4 auf. Ferner kann ihr ein Versteifungselement 5 zugeordnet sein. Der Kontaktkopf 2 weist eine Vielzahl von Prüfkontakten 6 auf, die als Prüfnadeln 7, insbesondere Prüfknicknadeln 8 ausgebildet und längsverschieblich in Führungslöchern von Führungselementen 9, 10 gehalten sind. Das Führungselement 9 ist ein testerseitiges Führungselement, weil es auf der Testerseite der Kontaktiervorrichtung 1 liegt, es ist also der Verbindungsvorrichtung 3 zugeordnet. Das Führungselement 11 ist dem Prüfling zugeordnet, liegt also abgewandt von der Verbindungsvorrichtung 3. Zwischen den Führungselementen 9 und 10 ist eine Haltevorrichtung 11 angeordnet. Die Prüflcontakte 6 sind über eine Fläche angeordnet, die eine Prüffläche 12 darstellt. Die der Verbindungsvorrichtung 3 zugeordneten Enden der Prüfkontakte 6 stehen im Berührungskontakt mit Kontaktflächen 13 der Verbindungsvorrichtung 3, insbesondere von Leiterbahnen 14 der gedruckten Leiterplatte 4. Die Leiterbahnen 14 führen zu Kontaktflächen 15, die mit einem Testgerät (nicht dargestellt) verbunden werden können. Die Kontaktflächen 13 befinden sich auf der einen und die Kontaktflächen 15 auf der anderen Seite der Leiterplatte 4. Die der Verbindungsvorrichtung 3 abgewandten Enden der Prüfkontakte 6 können in Berührungskontakt mit einem nicht dargestellten Prüfling, insbesondere Wafer, gebracht werden, was insbesondere dadurch erfolgt, dass der Prüfling auf die Kontaktiereinrichtung 1 zu bewegt wird, um mittels des Testgeräts Strompfade zum Prüfling zu schalten und diesen auf elektrisch korrekte Funktion zu prüfen. Die Mittenabstände der Prüfkontakte 6 liegen im Bereich von 50 µm bis 250 µm, das heißt, sie liegen sehr eng beieinander, was demzufolge auch für die Kontaktflächen 13 zutrifft. Aufgrund der sehr kleinen Abmessungen ist es von besonderer Bedeutung, dass die der Kontaktvorrichtung 3 zugeordneten Enden der Prüfkontakte 6 auf die ihnen zugeordneten Kontaktflächen 13 beim Prüfen eines Prüflings auftreffen oder an ihnen anliegen, um die Prüfstromwege realisieren zu können. Durch Temperaturspiel können sich Seitenversätze einstellen, sodass eine Kontaktierung bestimmter Prüfkontakte 6 mit den zugehörigen Kontaktflächen 13 nicht mehr möglich ist. Erfindungsgemäß ist hier Abhilfe geschaffen. Hierauf wird nachstehend noch näher eingegangen. Um das Testgerät problemlos an die Kontaktflächen 15 der Verbindungsvorrichtung 3 anschließen zu können, liegen diese mit größeren Mittenabständen zueinander, als die Kontaktflächen 13.

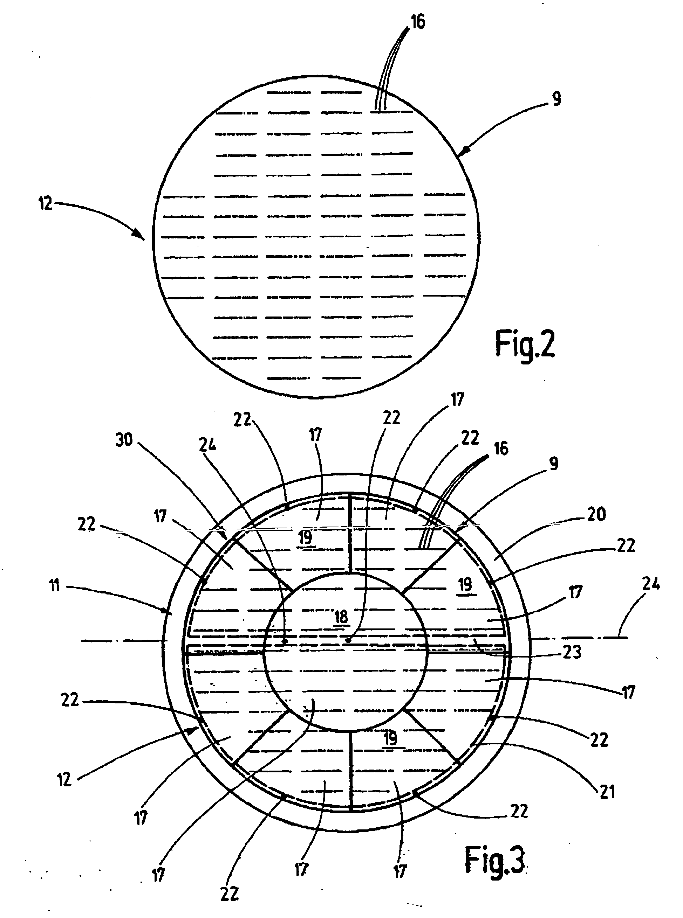

Die Figur 2 zeigt eine Draufsicht auf das Führungselement 9, das gemäß der bisherigen bekannten Bauform des Standes der Technik einstückig ausgebildet ist. Es weist eine Vielzahl von Bohrungen 16 zur Aufnahme der Prüfkontakte 6 auf. Die Bohrungen 16 sind reihenförmig angeordnet und zueinander sehr eng beabstandet positioniert.

Im Gegensatz zur Figur 2 zeigt die Figur 3 eine entsprechende Anordnung von Bohrungen 16 des Führungselements 9, wobei das Führungselement 9 sich jedoch erfindungsgemäß aus einer Vielzahl von Einzelsegmenten 17 zusammensetzt, das heißt, es liegt eine mehrstückige Anordnung vor. Im Ausführungsbeispiel der Figur 3 sind insgesamt neun Einzelsegmente 17 vorhanden. Es handelt sich dabei um ein kreisförmiges inneres Einzelsegment 18, das von acht äußeren Einzelsegmenten 19 umgeben wird. Demzufolge weisen die äußeren Einzelsegmente 19 im Wesentlichen jeweils eine Tortenstückform als Grundriss auf, wobei jedoch die Tortenstückspitze fehlt, da sich dort das innere Einzelsegment 18 befindet. Demzufolge ist die jeweilige, dem inneren Einzelsegment 18 zugeordnete Seite der äußeren Einzelsegmente 19 kreisbogenförmig gestaltet. Insgesamt wird auf diese Art und Weise eine kreisförmige Prüffläche 12 gebildet.

Die Haltevorrichtung 11 ist gemäß Figur 3 als Haltering 20 ausgebildet, der die äußeren Randbereiche der äußeren Einzelsegmente 19 nach innen hin überlappt. In dieser auf diese Art und Weise gebildeten Überlappungszone 21 befindet sich jeweils ein Festlager 22, das jeweils das zugehörige äußere Einzelsegment 19 spielfrei und unverrückbar mit der Haltevorrichtung 11 verbindet. Die jeweilige spielfreie Befestigung wird mittels Verstiftung erzeugt. Jedes äußere Einzelsegment 19 weist nur ein Festlager 22 auf.

Die Haltevorrichtung 11 weist einen Haltesteg 23 auf, der am Haltering 20 befestigt ist und entlang einer Halteringdiagonalen 24' verläuft. Das innere Einzelsegment 18 weist ebenfalls ein Festlager 22 auf, das etwa in dem Mittelpunkt der kreisförmigen Prüffläche 12 liegt und ebenfalls eine spielfreie Befestigung darstellt, die mit dem Haltesteg 23 besteht, das heißt, das innere Einzelsegment 18 ist über das Festlager 22 mit dem Haltesteg 23 spielfrei verbunden. Die Spielfreiheit aller Festlager 22 besteht in jeder innerhalb der Prüffläche 12 liegenden Richtung.

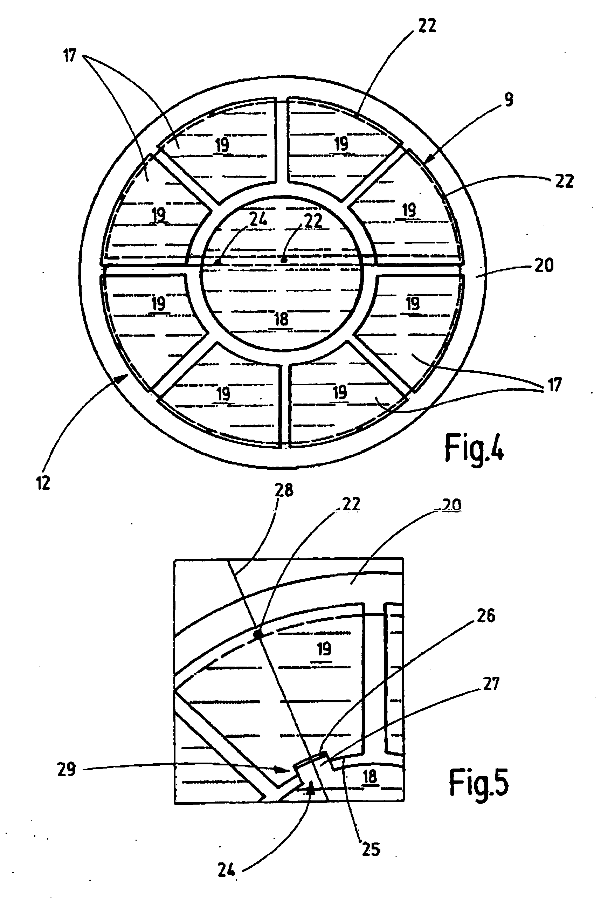

Jedes der Einzelsegmente 17 weist neben einem Festlager 22 ein Loslager 24 auf. Gemäß Figur 3 wird das Loslager 24, das beabstandet zum Festlager 22 des Einzelsegments 18 liegt bei dem inneren Einzelsegment 18, von einer Verbindung zum Haltesteg 23 gebildet, die ebenfalls als Verstiftung ausgebildet ist, wobei der am Haltesteg 23 befestigte Stift in einem Langloch des inneren Einzelsegmente 18 einliegt, sodass eine eindimensionale Führung besteht. Das Langloch erstreckt sich in Richtung einer gedachten Verbindungslinie zwischen dem Festlager 22 und dem Loslager 24 des inneren Einzelsegmertts 18. Auch die äußeren Einzelsegmente 19 weisen jeweils ein Loslager 24 auf. In den Figuren 3 und 4 sind diese Loslager 24 jedoch nicht eingezeichnet. In der Figur 5 wird auf die Loslager 24 der äußeren Einzelsegmente 19 näher eingegangen.

Gemäß Figur 5, die einen Ausschnitt aus der Anordnung gemäß Figur 3 beziehungsweise 4 zeigt, weist jedes äußere Einzelsegment 19 das Festlager 22 und das bereits erwähnte Loslager 24 auf. Das Loslager 24 ist dadurch gebildet, dass an einer dem inneren Einzelsegment 18 zugeordneten Seite 25 des jeweiligen äußeren Einzelsegments 19 eine Ausnehmung 26 ausgebildet ist, in die ein Vorsprung 27 des inneren Einzelsegments 18 derart eingreift, dass eine eindimensionale Führung gebildet ist. Diese eindimensionale Führung besteht entlang einer gedachten Verbindungslinie 28, die das Festlager 22 mit dem Loslager 24 des betrachteten äußeren Einzelsegments 19 verbindet. Quer dazu besteht eine spielfreie Verbindung zwischen dem betrachteten äußeren Einzelsegment 19 und dem inneren Einzelsegment 18, das heißt, der Vorsprung 27 hat zur Seite hin kein Spiel in der zugehörigen Ausnehmung 26. Insgesamt wird auf die beschriebene Art und Weise jedes äußere Einzelsegment 19 über eine Vorsprungs-/Ausnehmungsverbindung 29 mit dem inneren Einzelsegment 18 verbunden, wobei die Vorsprungs-IAusnehmungsverbindung 29 jeweils von einem Vorsprung 27 und einer Ausnehmung 26 gebildet wird. Die Anordnung ist dabei stets so getroffen, dass das Festlager 22 und das Loslager 24 jedes äußeren Einzelsegments 19 mit Abstand zueinander liegen, wobei die jeweils zu bildende, gedachte Verbindungslinie 28 den Mittelpunkt der Prüffläche 12 schneidet oder nahe am Mittelpunkt der Prüffläche 12 vorbeiführt.

Ein Vergleich der Figuren 3 und 4 zeigt, dass unterschiedliche Abstände zwischen benachbarten äußeren Einzelsegmenten 19 und auch unterschiedliche Abstände der äußeren Einzelsegmente 19 zu dem inneren Einzelsegment 18 bestehen. Diese Verlagerungen resultieren aus unterschiedlicher Temperaturbeaufschlagung, das heißt, die Anordnung der Figur 3 liegt bei "Normaltemperatur" vor, während die Anordnung der Figur 4 im erwärmten Zustand vorliegt. Hierzu ist zu bemerken, dass es bei der Prüfung eines Prüflings zu erheblichen Temperaturbeaufschlagungen kommt, wobei die unterschiedlichen Materialien der Kontaktiervorrichtung 1 unterschiedliche Temperaturen erreichen. Die Tests finden in weiten Temperaturbereichen, beispielsweise von -40°C bis +150°C (Temperatur des zu kontaktierenden Prüflings, insbesondere Wafers) statt; in Einzelfällen auch noch darüber oder darunter. Dabei nimmt die Kontaktiervorrichtung 1 teilweise die Temperaturen des Prüflings an, wobei sich innerhalb der Kontaktiervorrichtung 1 Temperaturgradienten, vor allem in Richtung vom Prüfling zum Testgerät (Tester) ausbilden. Üblicherweise ist die Testerseite der Kontaktiervorrichtung 1 nur der Raumtemperatur ausgesetzt.

Aufgrund der erfindungsgemäßen Separierung des Führungselements 9, das der Verbindungsvorrichtung 3 zugeordnet ist, sind relativ kleinflächige Einheiten geschaffen, sodass sich Längenänderungen, beispielsweise von einem äußeren Einzelsegment 19, die aufgrund von Temperaturspielen auftreten, nicht derart stark bemerkbar machen, dass die zugeordneten Prüfkontakte 6 nicht mehr die Kontaktflächen 13 der Verbindungsvorrichtung 3 kontaktieren. Viel größere Versetzungen stellen sich bei dem Führungselement 9 des Standes der Technik (Figur 2) ein, da sich Abweichungen über den Durchmesser der Prüffläche 12 gesehen, also über ein großflächiges Gebiet, viel stärker aufsummieren. Bei der Erfindung hingegen (Figur 3) sorgt das jeweilige Festlager 22 dafür, dass das jeweilige Einzelsegment 17 an der Stelle des Festlagers 23 starr gehalten wird und sich in der durch das jeweilige Loslager 24 definierten eindimensionalen Richtung verlagern kann, wobei die Verlagerungswerte relativ klein sind, da die Einzelflächen der Einzelsegmente 17 entsprechend klein gestaltet sind.

Wie bereits erwähnt, kommt hinzu, dass die Bauteile der Kontaktiervorrichtung 1 aus unterschiedlichen Materialien bestehen, die unterschiedliche Temperaturausdehnungskoeffizienten aufweisen. Da diese Materialien beziehungsweise Bauteile im Test unterschiedliche Temperaturen erreichen, entstehen Verschiebungen der einzelnen Bauteile zueinander, wie sie bereits vorstehend erläutert wurden. Selbst dann, wenn bei unterschiedlichen Temperaturen die Zentren von Führungselement 9 und Verbindungsvorrichtung 3 genau aufeinander liegen, also die Prüfkontakte 6 im Bereich des Zentrums genau mit den zugehörigen Kontaktflächen 13 der Verbindungsvorrichtung 3 korrespondieren, können entsprechende Abweichungen am Rande der Prüffläche 12 bestehen, sodass sich bei der bekannten Ausführungsform des Standes der Technik (Figur 2) die randseitigen Prüfnadeln 7 mit den zugehörigen Kontaktflächen 13 nicht mehr treffen. Da gemäß Figur 3 jedoch bei der Erfindung eine Einzelsegment-Bauweise realisiert ist, werden derart große Längenunterschiede nicht auftreten und damit eine sichere Kontaktierung stattfinden. Dies ist selbst bei sehr großen Prüfungsbildern (Prüfflächen 12), wie zum Beispiel 100 mm bis 320 mm Durchmesser, der Fall.

Bevorzugt ist die Anordnung derart getroffen, dass das Führungselement 9 einen von der Verbindungsvorrichtung 3 abweichend Temperaturausdehnungskoeffizienten aufweist. Zusätzlich oder alternativ kann vorzugsweise vorgesehen sein, dass die Haltevorrichtung 11 einen vom Führungselement 9 abweichenden Temperaturausdehnungskoeffizienten aufweist. Vorzugsweise ist dabei die Anordnung derart getroffen, dass die Summe der Temperaturausdehnungskoeffizienten von Führungselement 9 und Haltevorrichtung 11 dem oder etwa dem Temperaturausdehnungskoeffizienten der Verbindungsvorrichtung 3 entspricht. Dies führt dazu, dass die genannten Bauteile entsprechende Längenveränderungen bei unterschiedlichen Temperaturen durchlaufen, sodass stets eine Kontaktierung der Prüfkontakte 6 zu den Kontaktflächen 13 gewährleistet bleibt. Dies bedeutet, dass der Temperaturausdehnungskoeffizient der Haltevorrichtung 11 derart gewählt ist, dass innerhalb eines Temperaturbereichs die Berührungskontaktierung zwischen den Prüfkontakten 6 und den Kontaktflächen 13 der Verbindungsvorrichtung 3 erhalten bleibt.

Typischerweise weist die Verbindungsvorrichtung 3, insbesondere die Leiterplatte 4, einen sehr großen Temperaturausdehnungskoeffizienten (cirka 12 ppm/K bis 18 ppm/K) auf, wohingegen das Führungselement 9 einen eher kleinen Ausdehnungskoeffizienten von cirka 2 ppm/K bis zu 12 ppm/K, typischerweise 4 ppm/K, aufweist. (K = Kelvin).

Die Erfindung sieht insgesamt daher eine mehrteilige, an der Haltevorrichtung 1 gehaltene Führungsanordnung, nämlich des Führungselements 9 vor, das vorzugsweise als Führungsplatte 30 ausgebildet ist. Um die Größe/Position des Führungselements 9 bei unterschiedlichen Temperaturen der Größe der Verbindungsvorrichtung 3, insbesondere der Leiterplatte 4, anzupassen, wird die erfindungsgemäße Segmentbauweise (Einzelsegmente 17) gewählt. Dabei ist jedes Einzelsegment 17 für sich an ausgewählten Stellen mit der Haltevorrichtung 11 verbunden, insbesondere verstiftet. Damit ist bewirkt, dass die Position der Einzelsegmente 17 zueinander vom Temperaturausdehnungskoeffizienten und der absoluten Temperatur der Haltevorrichtung 11 bestimmt wird. Das Material der Haltevorrichtung 11 wird dabei so gewählt, dass sein Temperaturausdehnungskoeffizient bei vorgegebenen Temperaturen der Kontaktpartner (nach erfolgter Temperierung des Gesamtsystems) die optimale Größe zur Minimierung von Positionsfehlern aufweist. Hierfür stehen geeignete Materialien zur Verfügung, insbesondere nickelhaltige Ausdehnungslegierungen.

Für die Positionierung der Einzelsegmente 17 ist Folgendes vorgesehen: Das zentrale Element (inneres Einzelsegment 18) ist Ober zwei Zentrierstifte direkt an dem Haltesteg 23, der eine Verstrebung der Haltevorrichtung 11 darstellt, befestigt. Dabei wirkt einer der beiden Stifte als Festlager, indem er mit einem angepassten kreisförmigen Loch zusammenwirkt, und der andere als Loslager, indem er mit einem Langloch zusammenwirkt. Der als Festlager 22 wirkende Stift ist dabei vorzugsweise nahe des Zentrums der Prüffläche 12 angeordnet. Für die anderen Segmente, also die äußeren Einzeisegmente 19, ist ebenfalls jeweils eine der Fest-/Loslager-Anordnung vorhanden. Dabei ist das jeweilige Festlager 22 mittels eines Zentrierstifts in der Haltevorrichtung 11 und einer kreisförmigen Bohrung in dem jeweiligen Einzelsegment 19 gebildet und das Loslager 24 durch eine eindimensionale Führung zum zentralen, inneren Einzelelement 18. Eine gedachte Linie 28 zwischen dem jeweiligen Festlager 22 und dem jeweiligen Loslager 24 der Einzelsegmente 19 muss durch oder etwa durch das zentral angeordnete Festlager 22 des inneren Einzelelements 18 verlaufen. Die Gleitflächen der von den Loslegem 24 gebildeten eindimensionalen Führungen müssen dabei jeweils parallel oder etwa parallel zu dieser Linie 28 verlaufen.

Im dargestellten Ausführungsbeispiel wurde eine kreisförmige Anordnung mit neun Einzelsegmenten 17 gezeigt. Das gleiche Prinzip kann jedoch auf andere, zum Beispiel rechteckige, Platten- und Segmentformen übertragen werden. Die Aufteilung des Führungselements 9 muss mindestens in zwei Segmente erfolgen. Die maximale Anzahl der Segmente ergibt sich aus geometrischen und ökonomischen Erwägungen. Eine geometrische Erwägung ist die Anordnung der Führungs- und Befestigungselemente auf/an den jeweiligen Einzelsegmenten 17. Hinsichtlich der ökonomischen Erwägungen ist der Designaufwand zu berücksichtigen, der noch erträglich bleiben muss. Prinzipiell ist eine möglichst große Anzahl von Einzelsegmenten 17 optimal für eine gute Positionierung bei der Kontaktierung.

Aufgrund der Erfindung, bei der ein segmentiertes Führungselement 9 zum Einsatz kommt, ist die Ausrichtung der einzelnen Mikrobohrungen für die Aufnahme der Prüfkontakte 6 relativ zu den Kontaktflächen 13 der Verbindungsvorrichtung 3 verbessert. Da die Verbindungsvorrichtung 3, insbesondere die Leiterplatte 4, und das Führungselement 9 aus Materialien unterschiedlicher Temperaturausdehnungskoeffizienten bestehen, ist eine weitere Verbesserung möglich. Die Qualität der Fluchtungszuordnung von den Prüfkontakten 6 zu den Kontaktflächen 13 kann durch eine Veränderung des Temperaturgradienten, insbesondere vom Prüfling (insbesondere Wafer) in Richtung auf den Tester, in der Kontaktiervorrichtung 1 beeinflusst werden. Um bei vorgegebenem Material der Haltevorrichtung 11 und vorgegebenem Material für das Führungselement 9 weitere Einflussmöglichkeiten zu haben, kann zwischen der Haltevorrichtung 11 und dem Führungselement 9, insbesondere der Führungsplatte 30, eine Abstandsplatte beziehungsweise mindestens ein Abstandselement aus einem thermisch isolierend wirkenden Werkstoff, zum Beispiel einem Kunststoff, eingebaut werden. Dadurch ergibt sich eine kleinere Temperaturdifferenz zwischen dem Führungselement 9 und der Verbindungsvorrichtung 3 und zusätzlich eine geringere Abweichung zur Raumtemperatur. Im umgekehrten Fall, wenn eine größere Temperaturdifferenz gewünscht wird, kann diese Isolierschicht einfach weggelassen werden.

Alternativ oder zusätzlich zu der bereits aufgezeigten Lösung können die Einzelsegmente 17 des Führungselements 9 auch jeweils über Festlager 22 direkt mit der Verbindungsvorrichtung 3 verbunden werden. Hierzu werden als Festlager vorzugsweise Zentrierstifte genutzt, die direkt mit der Leiterplatte 4 der Verbindungsvorrichtung 3 verstiftet werden. Das Loslager 22 des jeweiligen Elements kann wahlweise in der vorstehend bereits aufgezeigten Form realisiert werden und/oder durch einen weiteren Zentrierstift oder dergleichen, der in ein Langloch eingreift, zur Verbindungsvorrichtung 3, insbesondere Leiterplatte 4. Alternativ kann der Zentrierstift für das jeweilige Loslager 24 auch mit der Haltevorrichtung 11 (Spacer) verbunden sein.

Aufgrund der Erfindung ist das Führungselement 9, insbesondere die Führungsplatte 30, mehrteilig ausgeführt und die Position der einzelnen Teile (Segmente) wird durch die Haltevorrichtung 11 bestimmt. Die Führung der einzelnen Teile (Einzelsegmente 17) erfolgt über Fest- und Loslager, wobei das Festlager mit der Haltevorrichtung 11 verbunden ist und das Loslager über eine Parallelführung eine Verbindung zum zentralen Element, also zum inneren Einzelsegment 18, herstellt. Die Verbindungslinie 28, die durch jeweils zugeordnete Fest- und Loslager 22, 24 führt, schneidet das Festlager 22 des zentralen Elements, also des inneren Einzelsegments 18, Es sind mindestens zwei oder drei Einzelsegmente 17 vorgesehen, die Anzahl kann aber auch deutlich höher sein. Eine praktische Grenze liegt im Bereich zwischen 50 und 100. Haltevorrichtung 11 und Leiterplatte 4 können zueinander mittenzentriert ausgerichtet sein. Das Führungselement 9 ist vorzugsweise thermisch zur Haltevorrichtung 11 isoliert. Das Führungselement 9 besteht beispielsweise aus Keramik. Eine nicht dargestellte Abwandlung der Erfindung kommt ohne ein zentrales Element, also ohne das innere Einzelsegment 18 aus. Dann befinden sich Fest- und Loslager 22, 24 als Ausrichtelemente, insbesondere Zentrierstifte, im Spacer, also in der Haltevorrichtung 11. In diesem Falle gibt es mindestens zwei Einzelsegmente 17. Die Einzelsegmente 17 können dann wie Tortenstücke kreisförmig angeordnet sein. Diese Tortenstücke weisen ihre Spitze jeweils auf (in Abwandlung zum Ausführungsbeispiel der Figur 3).

In Abwandlung zur Ausführungsform der Figuren 3 und 4 kann vorgesehen sein, dass die das Fest- und Loslager 22, 24 bildenden Zentrierstifte, die das innere Einzelsegment 18 positionieren nicht nur dieses mit dem Haltesteg 23 verbinden, sondern so lang ausgeführt sind, dass sie auch das innere Einzelsegment 18 mit dem Führungselement 10 verstiften. In einer Abwandlung dazu kann auch vorgesehen sein, dass der Zentrierstift des Loslagers 24 auch an anderer Stelle, als an dem Haltesteg 23 positioniert ist. Wichtig ist dabei jeweils der Gedanke, dass sichergestellt ist, dass sich das Zentrum des inneren Einzelsegments 18 durch diese Maßnahme genau über dem Zentrum des Führungselements 10 befindet und dass das innere Einzelsegment 18 keinen Rotations- Positionierfehler gegenüber dem Führungselement 10 aufweist. Der Haltesteg 23 hat insbesondere lediglich die Funktion, den Zentrierstift beziehungsweise die Zentrierstifte vertikal zu halten. Aus alledem ergibt sich, dass das Festlager 22 und/oder das Loslager 24 das innere Einzelsegment 18 mit dem dem Prüfling zugewandten Führungselement 10 ausrichtend verbindet. Dabei können Festlager 22 und/oder Loslager 24 mit der Haltevorrichtung 11, insbesondere dem Haltesteg 23, verbunden sein.

## Patentansprüche

1. Kontaktiervorrichtung für eine Berührungskontaktierung eines elektrischen Prüflings, insbesondere Wafers, mit einem Kontaktkopf und einer Verbindungsvorrichtung, wobei der Kontaktkopf mit dem Prüfling elektrisch berührungskontaktierbare Prüfkontakte aufweist, deren über eine Prüffläche verteilte Positionen von mindestens einem zum Kontaktkopf gehörenden Führungselement bestimmt sind, das an einer Haltevorrichtung des Kontaktkopfs befestigt ist, und wobei die Prüfkontakte auf ihrer dem Prüfling abgewandten Seite mit Kontaktflächen der Verbindungsvorrichtung in elektrische Berührungskontaktierung zu bringen sind, **dadurch gekennzeichnet, dass** sich das Führungselement (9) aus Einzelsegmenten (17) zusammensetzt, die jeweils einen Anteil der Prüffläche (12) aufweisen, wobei die Einzelsegmente (17) jeweils mittels mindestens eines Festlagers (22) mit der Haltevorrichtung (11) und/oder der Verbindungsvorrichtung (3) verbunden sind, das Festlager (22) als in der Prüffläche (12) spielfreie Befestigung ausgebildet ist und den Einzelsegmenten (17) jeweils mindestens ein Loslager (24) zugeordnet ist, das als in der Prüffläche (12) in nur einer Richtung mit Spiel versehene Befestigung ausgebildet ist.

2. Kontaktiervorrichtung nach Anspruch 1, **dadurch gekennzeichnet, dass** die Haltevorrichtung (11) einen Haltering (20) aufweist, in dessen Inneren die Prüffläche (12) liegt.

3. Kontaktiervorrichtung nach einem der vorhergehenden Ansprüche, **dadurch gekennzeichnet, dass** mindestens eines der Einzelsegmente (17) mittels seines Festlagers (22) mit dem Haltering (20) verbunden ist.

4. Kontaktiervorrichtung nach einem der vorhergehenden Ansprüche, **dadurch gekennzeichnet, dass** der Haltering (20) einen kreisförmigen oder einen rechteckigen, insbesondere quadratischen, Grundriss aufweist.

5. Kontaktiervorrichtung nach einem der vorhergehenden Ansprüche, **dadurch gekennzeichnet, dass** der Haltering (20) ein Vollring oder ein Teilring ist.

6. Kontaktiervorrichtung nach einem der vorhergehenden Ansprüche, **gekennzeichnet durch** mindestens ein Einzelsegment (17), das mit dem Haltering (20) verbunden ist und ein äußeres Einzelsegment (19) bildet, sowie mindestens ein Einzelsegment (17), das sich innerhalb des Halterings (20) befindet, jedoch nicht oder nicht direkt mit dem Haltering (20) verbunden ist und ein inneres Einzelsegment (18) bildet.

7. Kontaktiervorrichtung nach einem der vorhergehenden Ansprüche, **dadurch gekennzeichnet, dass** die Haltevorrichtung (11) einen Haltesteg (23) aufweist, an den mittels mindestens eines Festlagers (22) mindestens ein inneres Einzelsegment (18) befestigt ist.

8. Kontaktiervorrichtung nach einem der vorhergehenden Ansprüche, **dadurch gekennzeichnet, dass** der Haltesteg (23) am Haltering (20) befestigt ist.

9. Kontaktiervorrichtung nach einem der vorhergehenden Ansprüche, **dadurch gekennzeichnet, dass** der Haltesteg (23) entlang einer Halteringdiagonalen (24') verläuft.

10. Kontaktiervorrichtung nach einem der vorhergehenden Ansprüche, **dadurch gekennzeichnet, dass** das Loslager (24) zwischen mindestens einem Einzelsegment (17) und der Haltevorrichtung (11) und/oder der Verbindungsvorrichtung (3) einerseits und/oder zwischen mindestens einem Einzelsegment (17) und mindestens einem anderen Einzelsegment andererseits ausgebildet ist.

11. Kontaktiervorrichtung nach einem der vorhergehenden Ansprüche, **dadurch gekennzeichnet, dass** das Festlager (22) als in der Prüffläche (12) spielfreie Verstiftung ausgebildet ist.

12. Kontaktiervorrichtung nach einem der vorhergehenden Ansprüche, **dadurch gekennzeichnet, dass** das Loslager (24) als in der Prüffläche (12) in nur einer Richtung mit Spiel versehene Verstiftung ausgebildet ist.

13. Kontaktiervorrichtung nach einem der vorhergehenden Ansprüche, **dadurch gekennzeichnet, dass** eine gedachte Verbindungslinie (28) oder eine Verlängerung einer gedachten Verbindungslinie (28) zwischen Festlager (22) und Loslager (24) von jedem der äußeren Einzelsegmente (19) durch oder etwa durch einen Mittelpunkt der Prüffläche (12) verläuft, wobei das Spiel des zugehörigen Loslagers (24) nur in Richtung der Verbindungslinie (28) besteht.

14. Kontaktiervorrichtung nach einem der vorhergehenden Ansprüche, **dadurch gekennzeichnet, dass** das Festlager (22) des mindestens einen inneren Einzelsegments (18) im oder etwa im Mittelpunkt der Prüffläche (12) liegt.

15. Kontaktiervorrichtung nach einem der vorhergehenden Ansprüche, **dadurch gekennzeichnet, dass** die in der Prüfebene in nur einer Richtung mit Spiel versehene, das Loslager (24) bildende Befestigung zwischen dem einen und dem anderen Einzelsegment (17) als Vorsprungs-/Ausnehmungsverbindung (29), insbesondere von Bereichen des Führungselements (9), gebildet ist.

16. Kontaktiervorrichtung nach einem der vorhergehenden Ansprüche, **dadurch gekennzeichnet, dass** das Führungselement (9) einen von der Verbindungsvorrichtung (3) abweichenden Temperaturausdehnungskoeffizienten aufweist.

17. Kontaktiervorrichtung nach einem der vorhergehenden Ansprüche, **dadurch gekennzeichnet, dass** die Haltevorrichtung (11) einen vom Führungselement (9) abweichenden Temperaturausdehnungskoeffizienten aufweist.

18. Kontaktiervorrichtung nach einem der vorhergehenden Ansprüche, **dadurch gekennzeichnet, dass** die Summe der Temperaturausdehnungskoeffizienten von Führungselement (9) und Haltevorrichtung (11) dem oder etwa dem Temperaturausdehnungskoeffizienten der Verbindungsvorrichtung (3) entspricht.

19. Kontaktiervorrichtung nach einem der vorhergehenden Ansprüche, **dadurch gekennzeichnet, dass** der Temperaturausdehnungskoeffizient der Haltevorrichtung (11) derart gewählt ist, dass innerhalb eines Temperaturbereichs die Berührungskontaktierung zwischen den Prüfkontakten (6) und den Kontaktflächen (13) der Verbindungsvorrichtung (3) möglich ist.

20. Kontaktiervorrichtung nach einem der vorhergehenden Ansprüche, **dadurch gekennzeichnet, dass** die Verbindungsvorrichtung (3) als gedruckte Leiterplatte (4) ausgebildet ist.

21. Kontaktiervorrichtung nach einem der vorhergehenden Ansprüche, **dadurch gekennzeichnet, dass** die Kontaktflächen (13) von Leiterbahnflächen der gedruckten Leiterplatte (4) gebildet sind.

22. Kontaktiervorrichtung nach einem der vorhergehenden Ansprüche, **dadurch gekennzeichnet, dass** die Prüfkontakte (6) als Prüfnadeln (7), insbesondere Prüfknicknadeln (8), ausgebildet sind.

23. Kontaktiervorrichtung nach einem der vorhergehenden Ansprüche, **dadurch gekennzeichnet, dass** das Führungselement (9) als Führungsplatte (30) ausgebildet ist.

24. Verfahren zur Berührungskontaktierung eines elektrischen Prüflings, insbesondere Wafers, mit einem Kontaktkopf und einer Verbindungsvorrichtung, wobei der Kontaktkopf mit dem Prüfling elektrisch berührungskontaktierbare Prüfkontakte aufweist, deren über eine Prüffläche verteilte Positionen von mindestens einem zum Kontaktkopf gehörenden Führungselement bestimmt sind, das an einer Haltevorrichtung des Kontaktkopfs befestigt ist, und wobei die Prüfkontakte auf ihrer dem Prüfling abgewandten Seite mit Kontaktflächen der Verbindungsvorrichtung in elektrische Berührungskontaktierung gebracht werden, **dadurch gekennzeichnet, dass** sich das Führungselement (9) aus Einzelsegmenten (17) zusammensetzt, die jeweils einen Anteil der Prüffläche (12) aufweisen, wobei die Einzelsegmente (17) jeweils mittels mindestens eines Festlagers (22) mit der Haltevorrichtung (11) und/oder der Verbindungsvorrichtung (3) verbunden sind, das Festlager (22) als in der Prüffläche (12) spielfreie Befestigung ausgebildet ist und den Einzelsegmenten (17) jeweils mindestens ein Loslager (24) zugeordnet ist, das als in der Prüffläche (12) in nur einer Richtung mit Spiel versehene Befestigung ausgebildet ist.

## Claims

1. Contacting device for touch contacting an electrical test specimen, in particular a wafer, having a contact head and a connecting device, the contact head having test contacts that are electrically touch contactable with said test specimen, the positions of which are distributed across a testing surface and are determined by at least one guide element that belongs to the contact head and that is fastened to a holding device of the contact head, and wherein the test contacts, on their side facing away from the test specimen, are to be brought into electrical touch contact with contact surfaces of the connecting device, **characterized in that** the guide element (9) is composed of individual segments (17) that each have a part of the testing surface (12), the individual segments (17) each being connected to the holding device (11) and/or the connecting device (3) by means of at least one fixed bearing (22), the fixed bearing (22) being embodied as a fastening that is clearance-free in the testing surface (12), and at least one floating bearing (24) being assigned with each individual segment (17), the floating bearing (24) being embodied as a fastening that is provided with clearance in only one direction in the testing surface (12).

2. Contacting device according to claim 1, **characterized in that** the holding device (11) has a retaining ring (20) and that the testing surface (12) is disposed therein.

3. Contacting device according to any of the foregoing claims, **characterized in that** at least one of the individual segments (17) is connected to the retaining ring (20) by means of its fixed bearing (22).

4. Contacting device according to any of the foregoing claims, **characterized in that** the retaining ring (20) has a circular or rectangular, in particular square, outline.

5. Contacting device according to any of the foregoing claims, **characterized in that** the retaining ring (20) is a complete ring or a partial ring.

6. Contacting device according to any of the foregoing claims, **characterized by** at least one individual segment (17), that is connected to the retaining ring (20) and forms an outer individual segment (19), and at least one individual segment (17) that is located inside the retaining ring (20) but is not connected or is not directly connected to the retaining ring (20) and forms an inner individual segment (18).

7. Contacting device according to any of the foregoing claims, **characterized in that** the holding device (11) has a holding rib (23) to which at least one inner individual segment (18) is fastened by means of at least one fixed bearing (22).

8. Contacting device according to any of the foregoing claims, **characterized in that** said holding rib (23) is fastened to the retaining ring (20).

9. Contacting device according to any of the foregoing claims, **characterized in that** said holding rib (23) runs along a diagonal (24') of the retaining ring.

10. Contacting device according to any of the foregoing claims, **characterized in that** the floating bearing (24) is embodied between at least one individual segment (17) and the holding device (11) and/or the connecting device (3) on the one hand and/or between at least one individual segment (17) and at least one other individual segment on the other hand.

11. Contacting device according to any of the foregoing claims, **characterized in that** the fixed bearing (22) is embodied as a pinning that is clearance-free in the testing surface (12).

12. Contacting device according to any of the foregoing claims, **characterized in that** the floating bearing (24) is embodied as a pinning that is provided with clearance in only one direction in the testing surface (12).

13. Contacting device according to any of the foregoing claims, **characterized in that** an imaginary connecting line (28) or an extension of an imaginary connecting line (28) runs between the fixed bearing (22) and the floating bearing (24) of each of said outer individual segments (19) through or approximately through a center point of the testing surface (12), the clearance of the associated floating bearing (24) existing only in the direction of the connecting line (28).

14. Contacting device according to any of the foregoing claims, **characterized in that** the fixed bearing (22) of the at least one inner individual segment (18) is disposed in or approximately in the center point of the testing surface (12).

15. Contacting device according to any of the foregoing claims, **characterized in that** the fastening that is provided with clearance in only one direction in the testing plane and that forms the floating bearing (24) is formed as a projection/recess connection (29), in particular for areas of the guide element (9), between the one individual segment (17) and the other individual segment (17).

16. Contacting device according to any of the foregoing claims, **characterized in that** the guide element (9) has a temperature expansion coefficient that differs from that of the connecting device (3).

17. Contacting device according to any of the foregoing claims, **characterized in that** the holding device (11) has a temperature expansion coefficient that differs from that of the guide element (9).

18. Contacting device according to any of the foregoing claims, **characterized in that** the sum of the temperature expansion coefficients of the guide element (9) and holding device (11) are equal to or approximately equal to the temperature expansion coefficient of the connecting device (3).

19. Contacting device according to any of the foregoing claims, **characterized in that** the temperature expansion coefficient of the holding device (11) is selected such that touch contacting within a temperature range is possible between the test contacts (6) and the contact surfaces (13) of the connecting device (3).

20. Contacting device according to any of the foregoing claims, **characterized in that** the connecting device (3) is embodied as a printed circuit board (4).

21. Contacting device according to any of the foregoing claims, **characterized in that** the contact surfaces (13) are made from conductor surfaces of the printed surface board (4).

22. Contacting device according to any of the foregoing claims, **characterized in that** the test contacts (6) are embodied as test needles (7), in particular as buckling test needles (8).

23. Contacting device according to any of the foregoing claims, **characterized in that** the guide element (9) is embodied as guide plate (30).

24. Method for touch contacting an electrical test specimen, in particular a wafer, having a contact head and a connecting device, the contact head having test contacts that are electrically touch contactable with the test specimen, the positions of which are distributed across a testing surface and are determined by at least one guide element that belongs to the contact head and that is fastened to a holding device of the contact head, and wherein the test contacts, on their side facing away from the test specimen, are brought into electrical touch contact with contact surfaces of the connecting device, **characterized in that** the guide element (9) is composed of individual segments (17) each having a part of the testing surface (12), wherein the individual segments (17) are each connected to the holding device (11) and/or the connecting device (3) by means of at least one fixed bearing (22), the fixed bearing (22) is embodied as a fastening that is clearance-free in the testing surface (12), and at least one floating bearing (24) is associated with each individual segment (17), the floating bearing (24) being embodied as a fastening that is provided with clearance in only one direction in the testing surface (12).

## Revendications

1. Dispositif d'établissement de contacts pour un établissement de contacts par contact d'un objet d'essai électrique, notamment d'une tranche, avec une tête de contact et un dispositif de connexion, dans lequel la tête de contact présente des contacts d'essai pouvant établir des contacts par contact électrique avec l'objet d'essai dont les positions réparties sur une surface d'essai sont déterminées par au moins un élément de guidage appartenant à la tête de contact qui est fixé à un dispositif de maintien de la tête de contact, et dans lequel les contacts d'essai doivent être amenés en contact par contact électrique avec des surfaces de contact du dispositif de connexion sur leur côté détourné de l'objet d'essai, **caractérisé en ce que** l'élément de guidage (9) se compose de segments individuels (17) qui présentent chacun une portion de la surface d'essai (12), dans lequel les segments individuels (17) sont chacun reliés au moyen d'au moins un palier fixe (22) au dispositif de maintien (11) et/ou au dispositif de connexion (3), le palier fixe (22) est réalisé en tant que fixation exempte de jeu dans la surface d'essai (12) et au moins un palier libre (24) qui est réalisé en tant que fixation pourvue de jeu dans la surface d'essai (12) dans uniquement une direction est à chaque fois associé aux segments individuels (17).

2. Dispositif d'établissement de contacts selon la revendication 1, **caractérisé en ce que** le dispositif de maintien (11) présente un anneau de maintien (20) à l'intérieur duquel se situe la surface d'essai (12).

3. Dispositif d'établissement de contacts selon l'une quelconque des revendications précédentes, **caractérisé en ce qu'**au moins un des segments individuels (17) est relié à l'anneau de maintien (20) au moyen de son palier fixe (22).

4. Dispositif d'établissement de contacts selon l'une quelconque des revendications précédentes, **caractérisé en ce que** l'anneau de maintien (20) présente un plan circulaire ou un plan rectangulaire, notamment carré.

5. Dispositif d'établissement de contacts selon l'une quelconque des revendications précédentes, **caractérisé en ce que** l'anneau de maintien (20) est un anneau entier ou un anneau partiel.

6. Dispositif d'établissement de contacts selon l'une quelconque des revendications précédentes, **caractérisé par** au moins un segment individuel (17) qui est relié à l'anneau de maintien (20) et forme un segment individuel extérieur (19), ainsi qu'au moins un segment individuel (17) qui se trouve au sein de l'anneau de maintien (20), mais n'est pas ou pas directement relié à l'anneau de maintien (20) et forme un segment individuel intérieur (18).

7. Dispositif d'établissement de contacts selon l'une quelconque des revendications précédentes, **caractérisé en ce que** le dispositif de maintien (11) présente une traverse de maintien (23) à laquelle au moins un segment individuel intérieur (18) est fixé au moyen d'au moins un palier fixe (22).

8. Dispositif d'établissement de contacts selon l'une quelconque des revendications précédentes, **caractérisé en ce que** la traverse de maintien (23) est fixée à l'anneau de maintien (20).

9. Dispositif d'établissement de contacts selon l'une quelconque des revendications précédentes, **caractérisé en ce que** la traverse de maintien (23) s'étend le long d'une diagonale (24') de l'anneau de maintien.

10. Dispositif d'établissement de contacts selon l'une quelconque des revendications précédentes, **caractérisé en ce que** le palier libre (24) est réalisé entre au moins un segment individuel (17) et le dispositif de maintien (11) et/ou le dispositif de connexion (3) d'un côté et/ou entre au moins un segment individuel (17) et au moins un autre segment individuel de l'autre côté.

11. Dispositif d'établissement de contacts selon l'une quelconque des revendications précédentes, **caractérisé en ce que** le palier fixe (22) est réalisé en tant que fixation par goujon exempte de jeu dans la surface d'essai (12).

12. Dispositif d'établissement de contacts selon l'une quelconque des revendications précédentes, **caractérisé en ce que** le palier libre (24) est réalisé en tant que fixation par goujon pourvue de jeu dans la surface d'essai (12) dans uniquement une direction.

13. Dispositif d'établissement de contacts selon l'une quelconque des revendications précédentes, **caractérisé en ce qu'**une ligne de connexion imaginaire (28) ou un prolongement d'une ligne de connexion imaginaire (28) s'étend entre palier fixe (22) et palier libre (24) de chacun des segments individuels extérieurs (19) à travers ou approximativement à travers un point médian de la surface d'essai (12), dans lequel le jeu du palier libre associé (24) n'existe qu'en direction de la ligne de connexion (28).

14. Dispositif d'établissement de contacts selon l'une quelconque des revendications précédentes, **caractérisé en ce que** le palier fixe (22) de l'au moins un segment individuel intérieur (18) se situe dans ou approximativement dans le point médian de la surface d'essai (12).

15. Dispositif d'établissement de contacts selon l'une quelconque des revendications précédentes, **caractérisé en ce que** la fixation formant le palier libre (24), pourvue de jeu dans le plan d'essai dans uniquement une direction est formée entre l'un et l'autre segment individuel (17) en tant que connexion de saillie/d'évidement (29), notamment de régions de l'élément de guidage (9).

16. Dispositif d'établissement de contacts selon l'une quelconque des revendications précédentes, **caractérisé en ce que** l'élément de guidage (9) présente un coefficient de dilatation à la température déviant du dispositif de connexion (3).

17. Dispositif d'établissement de contacts selon l'une quelconque des revendications précédentes, **caractérisé en ce que** le dispositif de maintien (11) présente un coefficient de dilatation à la température déviant de l'élément de guidage (9).

18. Dispositif d'établissement de contacts selon l'une quelconque des revendications précédentes, **caractérisé en ce que** la somme des coefficients de dilatation à la température de l'élément de guidage (9) et du dispositif de maintien (11) correspond au ou approximativement correspond au coefficient de dilatation à la température du dispositif de connexion (3).

19. Dispositif d'établissement de contacts selon l'une quelconque des revendications précédentes, **caractérisé en ce que** le coefficient de dilatation à la température du dispositif de maintien (11) est choisi de telle sorte que l'établissement de contacts par contact entre les contacts d'essai (6) et les surfaces de contact (13) du dispositif de connexion (3) soit possible au sein d'une plage de température.

20. Dispositif d'établissement de contacts selon l'une quelconque des revendications précédentes, **caractérisé en ce que** le dispositif de connexion (3) est réalisé en tant que circuit imprimé (4).

21. Dispositif d'établissement de contacts selon l'une quelconque des revendications précédentes, **caractérisé en ce que** les surfaces de contact (13) sont formées par des surfaces de piste conductrice du circuit imprimé (4).

22. Dispositif d'établissement de contacts selon l'une quelconque des revendications précédentes, **caractérisé en ce que** les contacts d'essai (6) sont réalisés en tant qu'aiguilles d'essai (7), notamment aiguilles coudées d'essai (8).

23. Dispositif d'établissement de contacts selon l'une quelconque des revendications précédentes, **caractérisé en ce que** l'élément de guidage (9) est réalisé en tant que plaque de guidage (30).

24. Procédé pour l'établissement de contacts par contact d'un objet d'essai électrique, notamment d'une tranche, avec une tête de contact et un dispositif de connexion, dans lequel la tête de contact présente des contacts d'essai pouvant établir des contacts par contact électrique avec l'objet d'essai dont les positions réparties sur une surface d'essai sont déterminées par au moins un élément de guidage appartenant à la tête de contact qui est fixé à un dispositif de maintien de la tête de contact, et dans lequel les contacts d'essai sont amenés en contact par contact électrique avec des surfaces de contact du dispositif de connexion sur leur côté détourné de l'objet d'essai, **caractérisé en ce que** l'élément de guidage (9) se compose de segments individuels (17) qui présentent chacun une portion de la surface d'essai (12), dans lequel les segments individuels (17) sont chacun reliés au moyen d'au moins un palier fixe (22) au dispositif de maintien (11) et/ou au dispositif de connexion (3), le palier fixe (22) est réalisé en tant que fixation exempte de jeu dans la surface d'essai (12) et au moins un palier libre (24) qui est réalisé en tant que fixation pourvue de jeu dans la surface d'essai (12) dans uniquement une direction est à chaque fois associé aux segments individuels (17).
